# EUROPEAN PATENT APPLICATION

(11) **EP 2 400 592 A1**
(43) Date of publication of application: **28.12.2011**
(21) Application number: 11250425.3
(22) Date of filing: 04.04.2011
(51) Int. Cl.: H01Q 1/40, H01Q 1/24, H01Q 1/38, H01Q 23/00

(54) **Case of electronic device having an antenna with an active module embedded therein and an electronic device having the same**

(30) Priority: 28.06.2010 KR 20100061439
(71) Applicant: Samsung Electro-Mechanics Co., Ltd., Gyeonggi-do (KR)
(72) Inventor: Nam, Hyun Kil, Gyunggi-do (KR); Sung, Jae Suk, Gyunggi-do (KR); Cho, Sung Eun, Suwon, Gyunggi-do (KR); Park, Hyun Do, Gyunggi-do (KR); Han, Chang Mok, Suwon, Gyunggi-do (KR); Lim, Dae Ki, Gyunggi-do (KR); Bae, Sang Woo, Gyunggi-do (KR); Chang, Ki Won, Gyunggi-do (KR); Jeon, Dae Seong, Gyunggi-do (KR)
(74) Representative: Powell, Timothy John

(57) **Abstract**

There is provided a case having an antenna with an active module and an electronic device having the same. The case of an electronic device according to the present invention may include a radiator including an antenna pattern part transmitting and receiving signals, an active module spaced apart from a ground of a main circuit board and integrally formed with the radiator so as to interrupt the influence of noise during the transmitting and receiving of the signals to and from the radiator, and a frame formed to embed the radiator and the active module in the case.

## Description

### CROSS-REFERENCE TO RELATED APPLICATIONS

This application claims the priority of Korean Patent Application No. 10-2010-0061439 filed on June 28, 2010, in the Korean Intellectual Property Office, the disclosure of which is incorporated herein by reference.

### BACKGROUND OF THE INVENTION

### Field of the Invention

The present invention relates to a case having an antenna with an active module and an electronic device having the same, and more particularly, to a case having an antenna with an active module spaced apart from a main circuit board so as to interrupt the influence of noise at the time of transmitting signals between an antenna and the main circuit board, and an electronic device having the same.

### Description of the Related Art

With the rapid development of a semiconductor integrated circuit and information and communication technology, various portable electronic devices, such as mobile phones, portable multimedia player (PMPs), personal digital assistants (PDAs), smart phones, laptops, and the like have become necessities in modern society.

Further, as portable electronic devices have come to be prevalently used, user demand is being ever more diversified. As a result, more convenient and multi-functional portable electronic devices have been developed continuously. For example, an active module having various functions such as digital broadcasting reception (for example, digital multimedia broadcasting (DMB)), navigation, Wibro, WiFi, Bluetooth, or the like, has been converged into portable electronic devices.

As such, in order to implement the active module in portable electronic device, the appearance and internal structure of the portable electronic device are complicated. In implementing a main circuit board for the electronic device having the complicated structure, it is difficult to design the main circuit board due to the space restriction thereof.

Further, there is a problem in that radiation characteristics of an antenna are deteriorated due to the influence of noise in a signal path to the antenna used to implement the functions of the active module.

### SUMMARY OF THE INVENTION

An aspect of the present invention provides a case allowing for increased use of a space in designing electronic devices while interrupting the interference of noise in a signal transmission path between an active module and an antenna, by forming the active module to be spaced apart from a ground of a main circuit board and integrally forming the active module with the antenna, when mounting the multi-functional active module in electronic devices, and an electronic device having the same.

According to an aspect of the present invention, there is provided a case of an electronic device, including: a radiator including an antenna pattern part transmitting and receiving signals; an active module spaced apart from a ground of a main circuit board and integrally formed with the radiator so as to interrupt the influence of noise during transmitting and receiving of the signals to and from the radiator; and a frame formed to embed the radiator and the active module in the case.

The case of an electronic device may further include a connection member electrically connecting the main circuit board to the active module. The connection member may be made of an elastic material elastically connecting the active module to the main circuit board. For example, the connection member may be a C-clip or a pogo-pin.

The radiator and the active module may be embedded in the case of the active module by an in-mold injection molding process.

The active module may include a connection terminal to be electrically connected to the main circuit board, and the connection terminal is exposed in the inside surface of the case.

The antenna pattern part may be formed of a conductor pattern formed on the frame and the active module may be mounted on the frame.

The frame may be formed of a printed circuit board.

The active module may perform at least one function of a low-noise amplifier (LNA), a tuner, a global positioning system (GPS), frequency modulation (FM), worldwide interoperability for microwave access (WIMAX), wireless broadband (WIBRO), terrestrial digital multimedia broadcasting (TDMB), digital video broadcasting - handheld (DVB-H), general packet radio service (GPRS), wideband code division multiple access (WCDMA), Bluetooth (BT), and a wireless lan (WIFI).

According to another aspect of the present invention, there is provided an electronic device, including: a main body including a main circuit board; a case in which a radiator transmitting and receiving signals and an active module spaced apart from a main circuit board and integrally formed with the radiator so as to interrupt the influence of noise during the transmitting and receiving of the signals to and from the radiator are embedded; and a connection member electrically connecting a connection terminal of the active module to the main circuit board.

The connection member may be made of an elastic material elastically connecting the active module to the main circuit board.

The electronic device may further include a frame supporting the radiator and the active module to be embedded in the case.

### BRIEF DESCRIPTION OF THE DRAWINGS

The above and other aspects, features and other advantages of the present invention will be more clearly understood from the following detailed description taken in conjunction with the accompanying drawings, in which:

FIG. 1 is a perspective view schematically showing a partially cutaway case of an electronic device, a mobile communications terminal according to an exemplary embodiment of the present invention;

FIG. 2 is a schematic perspective view of a case of a mobile communications terminal according to an exemplary embodiment of the present invention; and

FIG. 3 is a schematic cross-sectional view taken along line A-A' of FIG. 1.

### DETAILED DESCRIPTION OF THE PREFERRED EMBODIMENT

Exemplary embodiments of the present invention will now be described in detail with reference to the accompanying drawings. However, it should be noted that the spirit of the present invention is not limited to the embodiments set forth herein and those skilled in the art and understanding the present invention can easily accomplish retrogressive inventions or other embodiments included in the spirit of the present invention by the addition, modification, and removal of components within the same spirit, but those are construed as being included in the spirit of the present invention.

Further, like reference numerals will be used to designate like components having similar functions throughout the drawings within the scope of the present invention.

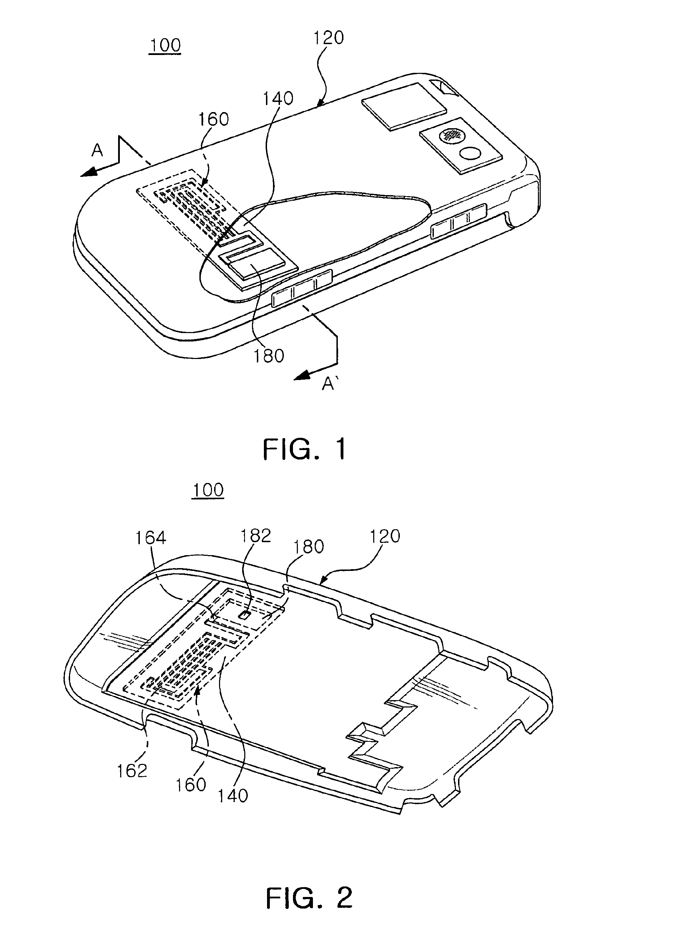

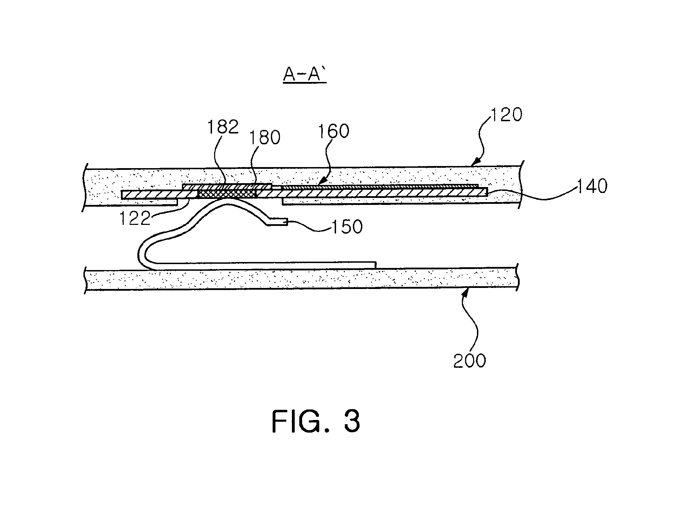

FIG. 1 is a perspective view schematically showing a partially cutaway case of an electronic device, a mobile communications terminal according to an exemplary embodiment of the present invention, FIG. 2 is a schematic perspective view of a case of a mobile communications terminal according to an exemplary embodiment of the present, and FIG. 3 is a schematic cross-sectional view taken along line A-A' of FIG. 1.

Referring to FIGS. 1 to 3, a radiator 160 and an active module 180 may be embedded in a case 120 of an electronic device, a mobile communications terminal 100 according to an exemplary embodiment of the present invention. A frame 140 supporting the radiator 160 and the active module 180 may be further provided so that the radiator 160 and the active module 180 are embedded in the case 120.

The radiator 160 is made of a conductive material such as aluminum, copper, or the like, to receive external signals and to transmit them to a signal processing unit in the electronic device such as the mobile communications terminal 100. Further, the radiator 160 may include the antenna pattern part 162 in order to receive the external signals of various bands.

The antenna pattern part 162 may be formed by applying a conductive material to one surface of the frame 140 and solidifying the conductive material. The antenna pattern part 162 may be formed on the frame 140 by at least one of a sputtering method, a printing method, a plating method, a stamping method, a drawing method, and a dispensing method.

In addition, the antenna pattern part 162 may be formed by performing press machining on a metal thin plate. Meanwhile, although the antenna pattern part 162 may be directly formed on the frame 140, it may be formed by applying a conductive material to a film or bonding the film to the frame 140 by pressing the press machining on the metal thin plate.

The shape of the antenna pattern part 162 may be variously formed according to a designed frequency band. For example, the shape of the antenna pattern part 162 may be a mender line or a loop antenna shape.

The active module 180 is formed in the frame 140 to be integrated with the radiator 160, without forming an RF path and a connection terminal 182 for electrically connecting the active module 182 with the main circuit board 200 may be formed on a surface opposite to a surface on which the active module 180 of the frame 140 is mounted.

The active module 180 may be a functional module, such as a low-noise amplifier (LNA), a tuner, or the like, a unidirectional communication module, such as a global positioning system (GPS), frequency modulation (FM), worldwide interoperability for microwave access (WIMAX), wireless broadband (WIBRO), terrestrial digital multimedia broadcasting (TDMB), digital video broadcasting - handheld (DVB-H), or the like, and a bidirectional communication module, such as cellular telephony, a general packet radio service (GPRS), wideband code division multiple access (WCDMA), Bluetooth (BT), and a wireless lan (WIFI), or the like. In the exemplary embodiment, the active module 180 may be configured, including at least one of the modules.

The frame 140 may be a plastic plate that is injection-molded with a polymer plastic injection solution and may serve as a primary injection product to embed the radiator 160 and the active module 180 in the case 120.

The radiator 160 including the antenna pattern part 162 and the active module 180 may be formed on one surface of the frame 140. It is preferable to form the radiator 160 and the active module 180 without forming the RF path. To this end, a connection terminal 164 of the radiator 160 may be connected to a connection terminal (not shown) of the radiator 160 of the active module 180 by a direct contact.

A connection terminal 182 of the main circuit board 200 of the active module 180 is formed to be exposed on a surface opposite to a surface on which the active module 180 of the frame 140 is mounted. To this end, the case 120 may have an opening 122 formed at a position corresponding to the connection terminal 182 of the frame 140.

Although the exemplary embodiment describes a case in which the opening 122 for exposing the connection terminal 182 is formed in the case 120, the present invention is not limited thereto. For example, the bottom surface of the frame 140 and the bottom surface of the case 120 may be formed to be positioned on the co-plane and the opening for exposing the connection terminal 182 may be formed on the frame 140.

Meanwhile, although the exemplary embodiment describes a configuration in which the connection terminal 182 on the main circuit board 200 of the active module 180 is exposed through the opening 122, the present invention is not limited thereto. For example, a through hole is formed in a thickness direction of the frame 140, a via conductor may be formed by filling a conductive paste in the through hole, and the connection terminal 182 may be formed by forming an external electrode at a position corresponding to the via conductor of the frame.

In addition, the frame 140 may be a printed circuit board on which a conductor pattern is printed. That is, the antenna pattern part 162 may be formed by printing a predetermined pattern on one surface of the frame 140 using a conductive ink, the connection terminal may be formed by forming an electrode on the end of the antenna pattern part 162, and the active module 180 may be mounted on the surface of the printed circuit board. In this case, a cavity is formed on the printed circuit board, such that the active module 180 may be embedded in the cavity. The connection terminal 182 on the main circuit board 200 of the active module 180 may be formed by the via conductor and the external electrode as described above.

The frame 140 mounted with the radiator 160 including the antenna pattern part 162 and the active module 180 are mounted in the case 120 so that the radiator 160 and the active module 180 are embedded in the case 120. That is, a surface opposite to the surface mounted with the radiator 160 and the active module 180 of the frame 140 is mounted towards the inside surface of the case 120. Therefore, the active module 180 is disposed to be spaced apart from the ground of the main circuit board 200 by a predetermined interval.

The frame 140 mounted with the radiator 160 and the active module 180 is inserted into a manufacturing mold of the case 120 and the radiator 160 and the active module 180 are embedded in the case 120 by filling a resin material in the manufacturing mold. Although the exemplary embodiment describes a case in which the frame 140 mounted with the radiator 160 and the active module 180 are embedded in the case by an insert injection molding process, the present invention is not limited thereto. The frame may be formed by being bonded to the case made of a plastic plate having the opening corresponding to the shape of the frame mounted with the radiator 160 and the active module 180.

Referring to FIG. 3, the main circuit board and the case 120 into which the radiator 160 and the active module 180 of the present invention are embedded are spaced apart from each other by a predetermined interval and a connection member 150 for electrically connecting the active module 180 to the main circuit board 200 is formed.

It is preferable that the connection member 150 is made of an elastic material that elastically couples the active module 180 to the main circuit board 200. Although the exemplary embodiment describes a case in which the active module and the main circuit board are connected by a C-clip, a pogo-pin, a slide type connector, or a vertical pressing type pin connector may be used.

Hereinafter, the difference between received signal strength indications (referred to as 'RSSI') for each frequency band in the electronic device according to an example of the present invention and the electronic device according to a comparative example will be described with reference to Table 1.

In Table 1, the example shows the electronic device according to the exemplary embodiment of the present invention. The example used an LAN as the active module and showed values measuring the RSSI by forming the LAN in the case of the electronic case to be integrated with the antenna while the LNA is spaced apart from the ground of the main circuit board. In addition, the comparative example showed values measuring the RSSI by disposing the antenna in the case of the electronic device and disposing the LNA on the main circuit board.

**[Table1]**

| Frequency (MHz) | RSSI(dBm) | |
|---|---|---|
| | Comparative Example | Example |
| 89.1 | 10 | 24 |
| 93.1 | 17 | 26 |
| 95.1 | 21 | 31 |
| 97.3 | 28 | 30 |
| 98.1 | 17 | 17 |
| 101.1 | 16 | 23 |
| 102.3 | 19 | 25 |
| 103.5 | 34 | 39 |
| 105.3 | 18 | 31 |
| 106.1 | 25 | 34 |
| 107.7 | 21 | 31 |

As shown in Table 1, it can be appreciated that the RSSI of the Example is larger than the Comparative Example in almost all frequency bands. The reason is that the example shortens the interference path of noise to the RF signal by integrally forming the active module, the LNA with the antenna, as compared to the Comparative Example having the interference path from the antenna of the case to the LNA of the main circuit board. Further, the reason is that the active module is spaced apart from the ground of the main circuit board to improve the radiation characteristics of the antenna.

As set forth above, according to the case of the electronic device and the electronic device having the same, the multi-functional active module is spaced apart from the ground of the main circuit board and is integrally formed with the antenna, thereby making it possible to improve the radiation characteristics of the antennal by interrupting the interference of noise in the signal transmission path between the active module and the antenna and increase the space use in designing the main circuit board.

While the present invention has been shown and described in connection with the exemplary embodiments, it will be apparent to those skilled in the art that modifications and variations can be made without departing from the spirit and scope of the invention as defined by the appended claims. The exemplary embodiment of the present invention describes, by way of example only, the configuration of forming the antenna pattern part or embedding the radiator and the active module in the case and therefore, various pattern forming methods or case molding methods may be used.

## Claims

1. A case of an electronic device, comprising:
a radiator including an antenna pattern part transmitting and receiving signals;
an active module spaced apart from a ground of a main circuit board and integrally formed with the radiator so as to interrupt the influence of noise during the transmitting and receiving of the signals to and from the radiator; and
a frame formed to embed the radiator and the active module in the case.

2. The case of an electronic device of claim 1, further comprising a connection member electrically connecting the main circuit board to the active module.

3. The case of an electronic device of claim 2, wherein the connection member is made of an elastic material elastically connecting the active module to the main circuit board.

4. The case of an electronic device of claim 2, wherein the connection member is a C-clip or a pogo-pin.

5. The case of an electronic device of claim 1, wherein the radiator and the active module are embedded in the case of the active module by an in-mold injection molding process.

6. The case of an electronic device of claim 1, wherein the active module includes a connection terminal to be electrically connected to the main circuit board, and
the connection terminal is exposed in the inside surface of the case.

7. The case of an electronic device of claim 1, wherein the antenna pattern part is formed of a conductor pattern formed on the frame and the active module is mounted on the frame.

8. The case of an electronic device of claim 1, wherein the frame is formed of a printed circuit board.

9. The case of an electronic device of claim 1, wherein the active module performs at least one function of a low-noise amplifier (LNA), a tuner, a global positioning system (GPS), frequency modulation (FM), worldwide interoperability for microwave access (WIMAX), wireless broadband (WIBRO), terrestrial digital multimedia broadcasting (TDMB), digital video broadcasting - handheld (DVB-H), a general packet radio service (GPRS), wideband code division multiple access (WCDMA), Bluetooth (BT), and a wireless lan (WIFI).

10. An electronic device, comprising:
a main body including a main circuit board;
a case in which a radiator transmitting and receiving signals and an active module spaced apart from a main circuit board and integrally formed with the radiator so as to interrupt the influence of noise during the transmitting and receiving of the signals to and from the radiator are embedded; and
a connection member electrically connecting a connection terminal of the active module to the main circuit board.

11. The electronic device of claim 10, wherein the connection member is made of an elastic material elastically connecting the active module to the main circuit board.

12. The electronic device of claim 10, further comprising a frame supporting the radiator and the active module to be embedded in the case.
